**Europäisches Patentamt**

**European Patent Office**

**Office européen des brevets**

(19)

(11) Veröffentlichungsnummer: **0 015 578**
A1

## (12) EUROPÄISCHE PATENTANMELDUNG

(21) Anmeldenummer: **80101183.4**

(22) Anmeldetag: **07.03.80**

(51) Int. Cl.³: **H 01 L 23/42**, H 01 L 23/40

(30) Priorität: **08.03.79 JP 29778/79**

(43) Veröffentlichungstag der Anmeldung: **17.09.80**
**Patentblatt 80/19**

(84) Benannte Vertragsstaaten: **AT BE CH DE FR GB NL SE**

(71) Anmelder: **FUJI ELECTRIC CO. LTD., 1-1, Tanabeshinden, Kawasaki-ku, Kawasaki 210 (JP)**

(72) Erfinder: **Shirai, Kiichiro, 6-11 Bessho-cho, Akashi-shi Hyogo (JP)**
Erfinder: **Yano, Kazuhiro, 7-2-19-31 Manabigaoka, Tarumi-ku Kobe-shi (JP)**

(74) Vertreter: **Mehl, Ernst, Dipl.-Ing., Postfach 22 01 76, D-8000 München 22 (DE)**

(54) **Siedegekühlte Halbleiteranordnung.**

(57) Die Erfindung betrifft eine siedegekühlte Halbleiteranordnung, wie sie in der gesamten Stromrichtertechnik verwendet wird. Die Halbleiteranordnung besteht aus einem Stapel von scheibenförmigen Halbleiterbauelementen (2) und Verdampfern (3), auf dessen Enden je ein Isolierstück (4) und auf einem Isolierstück (4) ein lagerartiger Teil (5) angeordnet sind. Der Stapel (1) mit den Bauteilen (4) und (5) ist in einen Spannverband (13) eingespannt. Der Stapel (1) ist von einem Kühlmittelbehälter (14) aus einem Mantel (20) und zwei Abschlussplatten (21, 22) umschlossen. Die Abschlussplatte (22) weist eine Öffnung zur Durchführung des einen Endes des Stapels (1) auf. Dieses Stapelende ist über ein Wellrohr (19) mit der Abschlussplatte (22) mechanisch gasdicht verbunden. Bei Längenänderungen des Stapels (1), die beim Einspannen des Stapels in den Spannverband (13) und durch thermische Schwankungen auftreten, gleitet das eine Stapelende in der Öffnung der Abschlussplatte (22). Das Wellrohr (19) wird dabei mitbewegt und es gewährleistet die mechanisch gasdichte Verbindung zwischen dem Behälter (14) und dem Ende des Stapels (1). Da der Spannverband (13) ausserhalb des Kühlmittelbehälters (14) verläuft, weist der Behälter (14) gegenüber bisherigen Ausführungen ein kleineres Volumen auf. Als Kühlmittel wird Freon verwendet.

0015578

Fuji Electric Co., Ltd
Kawasaki/Japan

Mein Zeichen
VPA 79 P 8 5 4 1 EUR

## Siedegekühlte Halbleiteranordnung

Die Erfindung betrifft eine siedegekühlte Halbleiteranordnung mit einem Stapel aus scheibenförmigen Halbleiterbauelementen und beidseits jedes Halbleiterbauelementes angeordneten Verdampfern und einem Spannverband, zwischen den die Enden des Stapels eingespannt sind, und einem mit verdampfbarem Medium gefüllten Kühlmittelbehälter mit zwei Abschlußplatten, in den wenigstens der Stapel eingetaucht ist.

Solche siedegekühlten Halbleiteranordnungen sind im Handel erhältlich. Bei diesen Einrichtungen ist ein Stapel von scheibenförmigen Halbleiterbauelementen, beispielsweise Scheibenthyristoren oder Scheibendioden, in ein flüssiges Kühlmedium eingetaucht und wird in ihm gekühlt. Leistungshalbleiterbauelemente erfordern die Ableitung und Abführung einer großen Verlustwärmemenge. Zur Kühlung von Halbleiterbauelementen werden nicht nur Kühlsysteme mit Luft, Wasser oder Öl, sondern auch Siedekühlsysteme mit leicht verdampfenden Kühlflüssigkeiten angewendet, beispielsweise mit einem unter dem Namen Freon im Handel erhältlichen Fluorkohlenwasserstoff. Eine Kühlflüssigkeit wie Freon hat einen Siedepunkt, der niedriger als die maximal erlaubte Betriebstemperatur der Halbleiterbauelemente ist, und kühlt daher die Halbleiterbauelemente durch Aufnahme der latenten Wärme beim Verdampfen. Bei Kühlsystemen mit Wasser oder Öl sind die Halbleiterbauelemente entweder zwischen Kühldosen, die von der Kühlflüssigkeit durchströmt sind, wärmeleitend angeordnet, oder direkt in Öl eingetaucht. Bei Siedekühlung mit Freon sind die Halbleiterbauelemente in die Kühlflüssigkeit eingetaucht. Damit die gesamte von den Halbleiterbauelementen im Betriebs-

zustand erzeugte Überschußwärme von der Kühlflüssigkeit aufgenommen werden kann, sind zwischen den Halbleiterbauelementen gut wärmeleitend angeordnete Verdampfer erforderlich. Bei dieser Eintauchkühlmethode mit siedender Kühlflüssigkeit sind die Halbleiterbauelemente innerhalb eines mit dem Kühlmittel aufgefüllten Behälters elektrisch miteinander und mit einer äußeren Schaltung über die Behälterwand durchsetzende Stromdurchführungen verbunden. Zwischen den in einem Stapel angeordneten scheibenförmigen Halbleiterbauelementen und Verdampfern wird der elektrische Kontakt durch eine Anpreßkraft bewirkt, die von einem den Stapel umgebenden Spannverband auf den Stapel ausgeübt wird. Handelsübliche Siedekühlsysteme dieser Art weisen den Nachteil auf, daß der Stapel zusammen mit dem ihn umgebenden Spannverband in dem Behälter für die Kühlflüssigkeit untergebracht ist. Da der Spannverband keinen Beitrag zum Kühlvorgang und zur Verdampfung leistet, verursacht er ein zu großes, für die Kühlfunktion nicht erforderliches Behältervolumen. Eine weitere handelsübliche Ausführung, bei der ein Teil des Spannverbandes außerhalb des Behälters angeordnet ist, weist einen wesentlich kleineren Behälter für die Kühlflüssigkeit auf. Nachteilig ist jedoch bei dieser Ausführung, daß die den innerhalb und außerhalb des Behälters verlaufenden Spannverband verbindenden Zugstangen gas- und flüssigkeitsdicht und gleitend durch eine Abschlußplatte des Behälters geführt werden müssen. Solche Durchführungen für die Zugstangen sind erforderlich, da im normalen Betrieb bei dem Stapel durch thermische Schwankungen bedingte Längenänderungen auftreten können und daher nur in den Durchführungen bewegliche Zugstangen diese Längenänderungen ausgleichen können.

Der Erfindung liegt die Aufgabe zugrunde, eine siedegekühlte Halbleiteranordnung der eingangs genannten Art so auszubilden, daß das Volumen des Kühlmittelbehälters reduziert und auf abgedichtete Durchführungen in der einen

Abschlußplatte des Behälters verzichtet werden kann.

Erfindungsgemäß wird diese Aufgabe dadurch gelöst, daß das eine Ende des Stapels auf der einen Abschlußplatte aufliegt, daß die andere Abschlußplatte mit einer Öffnung zur Durchführung des anderen Stapelendes versehen und wenigstens im Bereich der Öffnung membranartig ausgebildet und mechanisch gasdicht mit dem Stapelende verbunden ist, und daß der Kühlmittelbehälter vom Spannverband umgeben ist.

Da das eine Ende des Stapels auf der einen Abschlußplatte aufliegt und die andere Abschlußplatte mit einer Öffnung zur Durchführung des anderen Stapelendes versehen und wenigstens im Bereich der Öffnung membranartig ausgebildet und mechanisch gasdicht mit dem Stapelende verbunden ist, können Längenänderungen des Stapels, die beim Spannen des Spannverbandes und durch thermische Schwankungen während des Betriebes der Halbleiteranordnung auftreten, ausgeglichen werden. Die die Öffnung enthaltende Abschlußplatte des Kühlmittelbehälters bewirkt mit der membranartigen Ausbildung bei Ausgleichsvorgängen eine gasdichte mechanische Verbindung zwischen dem Stapelende und dem Kühlmittelbehälter. Da der Kühlmittelbehälter vom Spannverband umgeben ist, weist der Behälter ein kleineres Volumen auf, das für die Kühlfunktion ausreichend ist. Da der Spannverband außerhalb des Behälters angebracht ist, verlaufen keine abgedichteten Durchführungen für Zugstangen durch eine der Abschlußplatten des Behälters, in denen die Zugstangen gleiten können.

Vorteilhaft ist es, den membranartig ausgebildeten Bereich der einen Abschlußplatte als Wellrohr auszubilden, weil dieses ein handelsübliches Teil ist und mit geringem Aufwand mechanisch gasdicht mit dem Ende des Stapels und der einen Abschlußplatte beispielsweise durch Löten oder Schweißen verbunden werden kann.

Anhand der Figuren 1 und 2 werden zwei handelsübliche Ausführungsformen von siedegekühlten Halbleiteranordnungen und anhand der Figuren 3 und 4 die erfindungsgemäße Ausführung beispielhaft dargestellt und beschrieben. Die in verschiedenen Figuren auftretenden gleichen Bauelemente sind mit gleichen Bezugszeichen versehen.

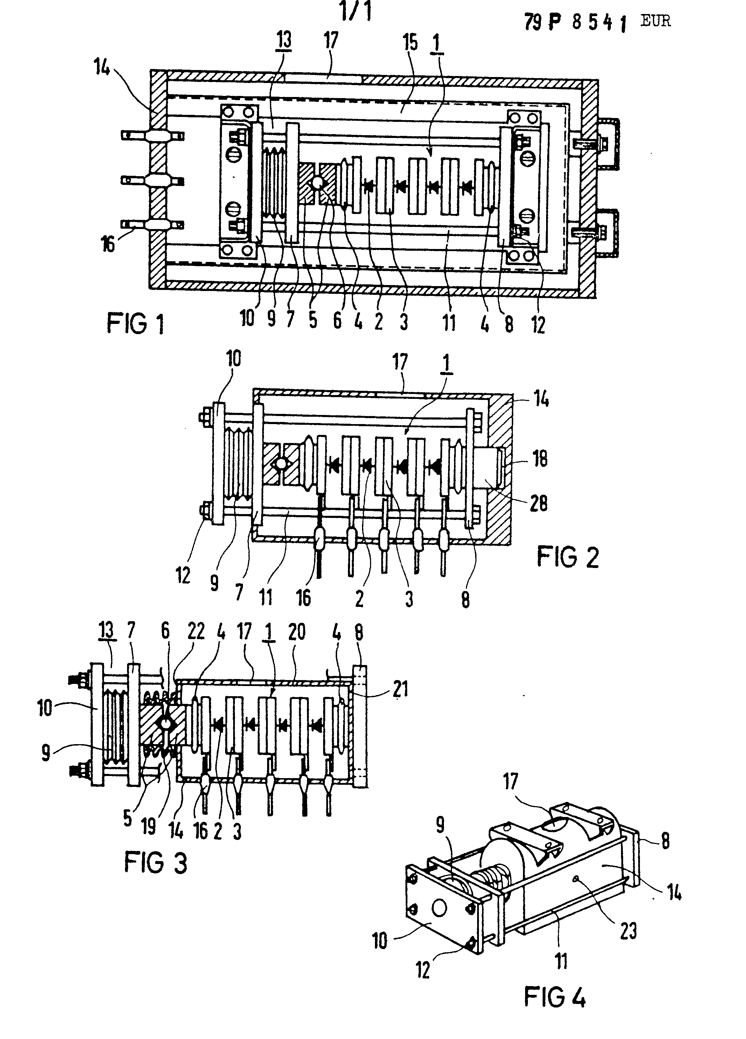

Figur 1 zeigt eine mit Freon siedegekühlte Halbleiteranordnung in handelsüblicher Ausführung. Ein Stapel 1 besteht aus scheibenförmigen Halbleiterbauelementen 2 und beidseits jedes Halbleiterbauelementes 2 angeordneten Verdampfern 3. Auf jedem der beiden Enden des Stapels 1 befindet sich ein Isolierstück 4. Das in Figur 1 rechts angeordnete Isolierstück 4 bildet das eine Ende des Stapels 1. Auf dem in Figur 1 links angeordneten Isolierstück 4 befindet sich ein zweiteiliger lagerartiger Bauteil 5 mit einer Stahlkugel 6. Dieser lagerartige Bauteil 5 bildet das andere Ende des Stapels 1. Der Stapel 1 mit den Bauteilen 4 bis 6 ist zwischen eine Platte 7 und eine erste Spannplatte 8 des Spannverbandes 13 eingespannt. Der Spannverband 13 besteht aus einer Platte 7, einer ersten Spannplatte 8, einer zweiten Spannplatte 10, einer Tellerfederanordnung 9 als elastischem Kraftspeicher zwischen der Platte 7 und der zweiten Spannplatte 10, den Zugstangen 11 und den Muttern 12. Die Platte 7 liegt stapelseitig auf dem Bauteil 5 auf und grenzt mit ihrer anderen Seite an die Tellerfederanordnung 9. Der Spannverband wird durch die Muttern 12 gespannt. Die von den Tellerfedern 9 ausgehende Anpreßkraft drückt auf den Stapel 1 und erzeugt dadurch zwischen allen Halbleiterbauelementen 2 und allen Verdampfern 3 einen elektrischen Kontakt. Die zweite Spannplatte 10 steht in elektrischem Kontakt mit dem einen Ende der Tellerfederanordnung 9. Der Spannverband 13 mit dem eingespannten Stapel ist in einem Kühlmittelbehälter 14 angebracht. Der Kühlmittelbehälter 14 ist mit einem flüssigen Kühlmedium, beispielsweise Freon, aufgefüllt. Der Spannverband 13 mit dem eingespannten Stapel ist an im Behälter 14 montierten Stäben befestigt. Über Stromdurchführungen 16 in der Wand des Behälters 14 ist der Stapel mit einer nicht dargestellten äußeren Schaltung verbunden. Das flüssige Freon siedet durch die Aufnahme der Verlustwärme der Halbleiterbauelemente 2. Das entstehende Freongas wird durch eine Öffnung 17 in eine nicht dargestellte Kondensationskammer geleitet, wo es verflüssigt wird und wieder in den Behälter 14 zurückfließt. Der Spannverband 13, der nicht zur Kühlung der Halbleiterbauelemente 2 beiträgt, ist im Behälter 14 angebracht und in das Kühlmittel eingetaucht. Dadurch muß das Volumen des Behälters 14 größer sein als ein für die Kühlung der Halbleiterbauelemente 2 ausreichendes Volumen.

Figur 2 zeigt eine weitere handelsübliche Ausführung einer siedegekühlten stapelförmigen Halbleiteranordnung, in der der Nachteil der Ausführung nach Figur 1 verringert ist. Der Stapel 1 ist zwischen der Platte 7 und der ersten Spannplatte 8 in ähnlicher Weise wie im Fall der Figur 1 der Anpreßkraft durch die Tellerfedern 9 ausgesetzt. Die Tellerfederanordnung 9 ist jedoch außerhalb des Kühlmittelbehälters 14 angebracht. Die erste Spannplatte 8 ist mit einem zapfenartigen Teil 28 versehen, der in das Loch 18 in der einen Abschlußplatte des Behälters 14 paßt, und so angebracht, daß sie bezüglich der ihr gegenüberliegenden Abschlußplatte des Behälters eingestellt ist und von axialen Schwankungen des Stapels 1 während der Einstellung der Anpreßkraft und während des laufenden Betriebs der Halbleiteranordnung freigehalten werden kann. Bei dieser Ausführung ist das Volumen des Kühlmittelbehälters 14 kleiner als bei der Ausführung nach Figur 1. Die Größe der gesamten Halbleiteranordnung weist dadurch geringere Abmessungen auf. Nachteilig ist, daß die Zugstangen 11 abgedichtet und gleitend durch die Wand des Behälters 14, d.h. durch die Platte 7 geführt werden müssen. Da sich bis zum Erreichen eines stationären Betriebszustandes die Halbleiterbauelemente 2 und die Verdampfer 3 des Stapels 1 ausdehnen können, ist es erforderlich, daß die Zugstangen 11 durch abgedichtete Durchführungen in der Platte 7 gleiten können.

In den Figuren 3 und 4 ist die erfindungsgemäße Halbleiteranordnung dargestellt. Der Stapel 1, der aus den scheibenförmigen Halbleiterbauelementen 2 und beidseits jedes Halbleiterbauelementes 2 angeordneten Verdampfern 3 besteht,
ist mit den beiden Isolierstücken 4 und dem die Stahlkugel
6 enthaltenden lagerartigen Bauteil 5 zwischen die Platte 7
und die erste Spannplatte 8 des Spannverbandes 13 eingespannt und der Anpreßkraft durch die Tellerfedern 9 ausgesetzt. Der Kühlmittelbehälter 14 umschließt den mit den
Bauteilen 4, 5 und 6 beaufschlagten Stapel 1. Der Kühlmittelbehälter 14 besteht aus einem Mantel 20 und zwei Abschlußplatten 21 und 22. Das eine mit dem einen Isolierstück 4 beaufschlagte, in der Figur 3 rechts liegende Ende
des Stapels 1 liegt auf der Abschlußplatte 21 des Behälters
14 auf. Die Abschlußplatte 22 ist mit einer zentralen Öffnung zur gleitenden Durchführung des linken Stapelendes in
Gestalt des Bauteiles 5 versehen. Die Abschlußplatte 22 ist
durch ein Wellrohr 19 mit dem Bauteil 5 mechanisch gasdicht
verbunden. Das Wellrohr 19 ist an der Abschlußplatte 22 und
dem Bauteil 5 beispielsweise durch Löten oder Schweißen befestigt. Das Wellrohr 19 gewährleistet bei Ausgleichsvorgängen, bei denen das eine Ende des Stapels 1 in Gestalt des
Bauteiles 5 in der Öffnung der Abschlußplatte 22 gleitet,
eine mechanisch gasdichte Verbindung zwischen dem Ende des
Stapels 1 und der Abschlußplatte 22. Solche Ausgleichsvorgänge laufen bei Längenänderungen des Stapels 1 ab, beispielsweise beim Einstellen der Anpreßkraft durch Spannen
des Spannverbandes 13 und bei durch thermische Schwankungen
bedingten Ausdehnungen und Zusammenziehungen des Stapels 1 während des Betriebes der Halbleiteranordnung. Die elastische Verbindung des Behälters 14 mit dem Ende des Stapels 1 kann auch durch eine mindestens teilweise membranartige Ausbildung der Abschlußplatte 22 erfolgen. Eine solche membranartige Abschlußplatte 22 wird an dem Mantel 20 und dem Bauteil 5 mechanisch gasdicht befestigt. Der Spannverband 13 ist außerhalb des Kühlmittelbehälters 14 angebracht, wie aus den Figuren 3 und 4 zu ersehen ist. Der Behälter 14 weist zwei Durchbrüche 17 und 23 auf. Durch die Öffnung 17 wird das Freongas aus dem Behälter 14 in eine nicht dargestellte Kondensationskammer geleitet und durch das Loch 23 fließt das kondensierte Freon aus der Kondensationskammer zurück in den Behälter. Der Behälter 14 ist mit Stromdurchführungen 16 durch die Wand des Behälters 14 ausgestattet. Über die Stromdurchführungen 16 werden die als Kontaktelemente dienenden Verdampfer 3 im Behälter 14 an eine äußere, nicht dargestellte Schaltung angeschlossen.

Da in der erfindungsgemäßen Halbleiteranordnung der Spannverband 13 nicht innerhalb des Kühlmittelbehälters 14 liegt, ist das Volumen des Behälters 14 kleiner als bei der Ausführung nach Figur 2, so daß die Größe der gesamten Halbleiteranordnung reduziert werden kann. Außerdem ist es nicht mehr erforderlich, die Zugstangen 11 abgedichtet und gleitend durch die eine Abschlußplatte des Behälters 14 zu führen. Schwankungen der Länge des Stapels 1, die durch Ausdehnung und Zusammenziehung der Halbleiterbauelemente 2 und der Verdampfer 3 während des Spannens des Spannverbandes 13 oder während des Betriebsablaufs durch thermische Schwankungen hervorgerufen werden, nimmt das Wellrohr 19 mühelos auf. Die siedegekühlte Halbleiteranordnung kann daher mit sehr guter Wirtschaftlichkeit und Betriebssicherheit hergestellt werden.

Die erfindungsgemäße siedegekühlte Halbleiteranordnung ist für die Verwendung in der gesamten Stromrichtertechnik bestimmt.

0015578

## Patentansprüche

1. Siedegekühlte Halbleiteranordnung mit einem Stapel aus scheibenförmigen Halbleiterbauelementen und beidseits jedes Halbleiterbauelementes angeordneten Verdampfern und einem Spannverband, zwischen den die Enden des Stapels eingespannt sind, und einem mit verdampfbarem Medium gefüllten Kühlmittelbehälter mit zwei Abschlußplatten, in den wenigstens der Stapel eingetaucht ist, d a d u r c h g e k e n n z e i c h n e t , d a ß das eine Ende des Stapels (1) auf der einen Abschlußplatte (21) aufliegt, daß die andere Abschlußplatte (22) mit einer Öffnung zur Durchführung des anderen Stapelendes versehen und wenigstens im Bereich der Öffnung membranartig ausgebildet und mechanisch gasdicht mit dem Stapelende verbunden ist, und daß der Kühlmittelbehälter (14) vom Spannverband (13) umgeben ist.

2. Siedegekühlte Halbleiteranordnung nach Anspruch 1, d a d u r c h g e k e n n z e i c h n e t , d a ß der membranartig ausgebildete Bereich der einen Abschlußplatte (22) ein Wellrohr (19) ist.

FIG 1

FIG 2

FIG 3

FIG 4

| EINSCHLÄGIGE DOKUMENTE | | | KLASSIFIKATION DER ANMELDUNG (Int.Cl. 3) |
|---|---|---|---|
| Kategorie | Kennzeichnung des Dokuments mit Angabe, soweit erforderlich, der maßgeblichen Teile | betrifft Anspruch | H 01 L 23/42 23/40 |
| | US - A - 3 972 063 (MITSUBISHI)<br><br>* Figur 3 ; Spalte 6, Zeile 67 - Spalte 7, Zeile 13 *<br><br>-- | 1 | |
| | US - A - 4 020 399 (MITSUBISHI)<br><br>* Figuren 1,2; Spalte 2, Zeile 39 - Spalte 4, Zeile 32 *<br><br>-- | 1 | |
| | DE - A - 2 417 106 (SIEMENS)<br><br>* Ansprüche 1-3 *<br><br>---- | 1,2 | RECHERCHIERTE SACHGEBIETE (Int. Cl. 3)<br><br>H 01 L 23/42 23/40 |

KATEGORIE DER GENANNTEN DOKUMENTE

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 30-05-1980 | DE RAEVE |

EPA form 1503.1 06.78